# EUROPÄISCHE PATENTSCHRIFT

(11) **EP 2 449 552 B1**
(45) Veröffentlichungstag und Bekanntmachung des Hinweises auf die Patenterteilung: **01.04.2015**
(21) Anmeldenummer: 10725067.2
(22) Anmeldetag: 21.05.2010
(51) Int. Cl.: G10K 9/122, G10K 9/18, G01F 1/66, H01L 41/08

(54) **ULTRASCHALL-DURCHFLUSSMESSGERÄT**
ULTRASONIC FLOW METER
DÉBITMÈTRE À ULTRASONS

(30) Priorität: 30.06.2009 DE 102009027355
(43) Veröffentlichungstag der Anmeldung: 09.05.2012
(73) Patentinhaber: Endress+Hauser Flowtec AG, 4153 Reinach (CH)
(72) Erfinder: MÜLLER, Quirin, CH-4132 Muttenz (CH); KISSLING, Beat, CH-Reinach 4153 (CH)
(74) Vertreter: Andres, Angelika Maria
(86) Internationale Anmeldenummer: PCT/EP2010/057057
(87) Internationale Veröffentlichungsnummer: WO 2011/000634

(56) Entgegenhaltungen:
- EP-A1- 0 260 335
- DE-A1- 19 725 717
- US-A1- 2007 001 031
- US-A1- 2007 247 019

## Beschreibung

Die vorliegende Erfindung betrifft einen Ultraschallsensor mit zumindest einem elektromechanischen Wandlerelement und einem Elektrodenstempel, welcher Elektrodenstempel eine erste Oberfläche des elektromechanischen Wandlerelements elektrisch kontaktiert.

Ultraschall-Durchflussmessgeräte werden vielfach in der Prozess- und Automatisierungstechnik eingesetzt. Sie erlauben in einfacher Weise, den Volumendurchfluss und/oder Massendurchfluss in einer Rohrleitung zu bestimmen.

Die bekannten Ultraschall-Durchflussmessgeräte arbeiten häufig nach dem Doppleroder nach dem Laufzeitdifferenz-Prinzip. Beim Laufzeitdifferenz-Prinzip werden die unterschiedlichen Laufzeiten von Ultraschallimpulsen relativ zur Strömungsrichtung der Flüssigkeit ausgewertet. Hierzu werden Ultraschallimpulse in einem bestimmten Winkel zur Rohrachse sowohl mit als auch entgegen der Strömung gesendet. Aus der Laufzeitdifferenz lässt sich die Fließgeschwindigkeit und damit bei bekanntem Durchmesser des Rohrleitungsabschnitts der Volumendurchfluss bestimmen.

Beim Doppler-Prinzip werden Ultraschallwellen mit einer bestimmten Frequenz in die Flüssigkeit eingekoppelt und die von der Flüssigkeit reflektierten Ultraschallwellen ausgewertet. Aus der Frequenzverschiebung zwischen den eingekoppelten und reflektierten Wellen lässt sich ebenfalls die Fließgeschwindigkeit der Flüssigkeit bestimmen. Reflexionen in der Flüssigkeit treten auf, wenn Luftbläschen oder Verunreinigungen in dieser vorhanden sind, so dass dieses Prinzip hauptsächlich bei verunreinigten Flüssigkeiten Verwendung findet.

Die Ultraschallwellen werden mit Hilfe so genannter Ultraschallwandler erzeugt bzw. empfangen. Hierfür sind Ultraschallwandler in der Rohrwandung des betreffenden Rohrleitungsabschnitts fest angebracht. Seit neuerem sind auch Clamp-on-Ultraschall-Durchflussmesssysteme erhältlich. Bei diesen Systemen werden die Ultraschallwandler nur noch mit einem Spannverschluss an die Rohrwandung gepresst. Ein großer Vorteil von Clamp-On-Ultraschall-Durchflussmesssystemen ist, dass sie das Messmedium nicht berühren und auf eine bereits bestehende Rohrleitung angebracht werden. Derartige Systeme sind z. B. aus der EP 686 255 B1, US-A 44 84 478 oder US-A 45 98 593 bekannt.

Ein weiteres Ultraschall-Durchflussmessgerät, das nach dem Laufzeitdifferenz-Prinzip arbeitet, ist aus der US-A 50 52 230 bekannt. Die Laufzeit wird hier mittels kurzen Ultraschallimpulsen, so genannten Bursts, ermittelt.

Die Ultraschallwandler bestehen normalerweise aus einem elektromechanischen Wandlerelement, z.B. ein piezoelektrisches Element, auch kurz Piezo genannt, und einer Koppelschicht, auch Koppelkeil oder seltener Vorlaufkörper genannt. Die Koppelschicht ist dabei meist aus Kunststoff gefertigt, das piezoelektrische Element besteht in der industriellen Prozessmesstechnik üblicherweise aus einer Piezokeramik. Im piezoelektrischen Element werden die Ultraschallwellen erzeugt und über die Koppelschicht zur Rohrwandung geführt und von dort in die Flüssigkeit geleitet. Da die Schallgeschwindigkeiten in Flüssigkeiten und Kunststoffen unterschiedlich sind, werden die Ultraschallwellen beim Übergang von einem zum anderen Medium gebrochen. Der Brechungswinkel bestimmt sich in erster Näherung nach dem Snell'schen Gesetz. Der Brechungswinkel ist somit abhängig von dem Verhältnis der Ausbreitungsgeschwindigkeiten in den Medien.

Zwischen dem piezoelektrischen Element und der Koppelschicht kann eine weitere Koppelschicht angeordnet sein, eine so genannte Anpassungsschicht. Die Anpassungsschicht übernimmt dabei die Funktion der Transmission des Ultraschallsignals und gleichzeitig die Reduktion einer durch unterschiedliche akustische Impedanzen verursachte Reflektion an Grenzschichten zwischen zwei Materialen.

Meist sind die elektromechanischen Wandlerelemente durch eine Klebung mit den Koppelelementen verbunden. Dies hat jedoch eine geringe Beständigkeit gegen Wärme- und/oder Kälteeintrag zur Folge; die Klebeschicht selbst kann degenerieren und dadurch die Verbindung lösen oder, bedingt durch unterschiedlichen thermischen Ausdehnungskoeffizienten der Bauteile, kann das elektromechanische Wandlerelement Spannungen bis zur Zerstörung ausgesetzt werden. Des Weiteren erfordert eine Klebung hohe Anforderungen an die Produktion, z.B. um Gaseinschlüsse in der Klebeschicht oder Verunreinigungen der zu klebenden Oberflächen zu verhindern. Die DE-197 25 717 offenbart eine solche Klebeschicht. Für Hochtemperaturanwendungen oder Anwendungen mit stark schwankenden Temperaturen kommen daher Ultraschallwellenleiter zum Einsatz, welche das elektromechanische Wandlerelement thermisch vom Koppelelement, welches das Messmedium direkt berührt, trennen. Durch diese örtliche Trennung von Schallwandlung zu Schalleinkopplung bzw. Schallauskopplung verringert sich zunehmend die Signalqualität.

Weiterhin sind auch fluide Koppelmittel bekannt geworden, meist Öle oder Fette, welche jedoch bei hohen Temperaturen ebenfalls mit großen Nachteilen behaftet sind.

Die EP 2 034 471 A2 offenbart nun einen Ultraschallsensor, insbesondere für einen Ultraschalldurchflussmesser, mit einem Gehäuse und einem in dem Gehäuse angeordneten Ultraschallwandlerelement, wobei mit dem Ultraschallwandlerelement Ultraschallsignale erzeugbar und/oder detektierbar sind und die Ultraschallsignale von dem Ultraschallwandlerelement über ein Ultraschallfenster des Gehäuses emittierbar und/oder empfangbar sind, dadurch gekennzeichnet, dass zwischen dem Ultraschallwandlerelement und dem Ultraschallfenster des Gehäuses eine dünne, relativ weiche Festkörper-Zwischenschicht vorgesehen ist, die mit der Festkörper-Zwischenschicht in Kontakt stehende Oberfläche des Ultraschallfensters eine vorgegebene Rauheit aufweist und der Ultraschallwandlerelement mit einer Kraft beaufschlagt ist, wobei die Materialien der Festkörper-Zwischenschicht und des Ultraschallfensters, die vorgegebene Rauheit der Oberfläche des Ultraschallfensters und die Kraft so aufeinander abgestimmt sind, dass die Festkörper-Zwischenschicht zumindest auch durch plastische Verformung an das Ultraschallfenster des Gehäuses angeschmiegt ist. Die elektrische Kontaktierung des Ultraschallwandlerelements erfolgt üblicherweise über zwei auf gegenüberliegenden Oberflächen des Ultraschallwandlerelements angebrachten Elektroden. Diese bedecken die Oberflächen des Ultraschallwandlerelements näherungsweise vollständig. Herkömmlicherweise sind die Elektroden stoffschlüssig mit dem elektromechanischen Ultraschallwandlerelement verbunden.

Die Aufgabe der Erfindung besteht darin, einen Ultraschallsensor mit verbessertem Wirkungsgrad bereit zu stellen.

Die Aufgabe wird gelöst durch ein Ultraschall-Durchflussmessgerät nach Anspruch 1 mit einem Ultraschallsensor mit zumindest einem elektromechanischen Wandlerelement und einem Elektrodenstempel, welcher eine erste Oberfläche des elektromechanischen Wandlerelements elektrisch kontaktiert, wobei höchstens 75% der Fläche der ersten Oberfläche des elektromechanischen Wandlerelements elektrisch kontaktiert sind, d.h. also dass höchstens 75% der Fläche der ersten Oberfläche des elektromechanischen Wandlerelements mit dem Elektrodenstempel, welcher gleichzeitig eine erste Elektrode zur elektrischen Kontaktierung des elektromechanischen Wandlerelements bildet, in Berührung stehen - die Kontaktfläche zwischen Elektrodenstempel und elektromechanischem Wandlerelement ist maximal so groß wie 75% der Fläche der gesamten ersten Oberfläche des elektromechanischen Wandlerelements. Eine zweite Oberfläche des elektromechanischen Wandlerelements, welche üblicherweise der ersten Oberfläche des elektromechanischen Wandlerelements gegenüber liegt, kann dabei gänzlich mit Elektrodenmaterial einer zweiten Elektrode bedeckt sein und diese ca. 100% der Fläche der zweiten Oberfläche des elektromechanischen Wandlerelements elektrisch kontaktieren. In einem Ausführungsbeispiel eines erfindungsgemäßen Sensors kontaktiert eine zweite Elektrode die zweite Oberfläche des elektromechanischen Wandlerelements elektrisch mit höchstens 75% der Fläche der ersten Oberfläche des elektromechanischen Wandlerelements. Insbesondere weisen die erste Oberfläche des elektromechanischen Wandlerelements und die zweite Oberfläche des elektromechanischen Wandlerelements die gleiche Fläche auf.

Gemäß einer ersten Weiterbildung der Erfindung sind höchstens 65% der Fläche der ersten Oberfläche des elektromechanischen Wandlerelements elektrisch kontaktiert, in einem weiteren Ausführungsbeispiel höchstens 55%, gemäß einer anderen Ausgestaltung höchstens 50%. Mindestens jedoch sind 15%, oder gemäß einem weiteren Ausführungsbeispiel mindestens 25% der Fläche der ersten Oberfläche des elektromechanischen Wandlerelements elektrisch kontaktiert. In einem weiteren Ausführungsbeispiel sind mindestens 30% der Fläche der ersten Oberfläche des elektromechanischen Wandlerelements elektrisch kontaktiert. Entsprechendes kann für die zweite Oberfläche des Oberfläche des elektromechanischen Wandlerelements gelten, d.h. also dass gemäß einer weiteren Ausgestaltung der Erfindung höchstens 65% der Fläche der zweiten Oberfläche des elektromechanischen Wandlerelements elektrisch kontaktiert sind, oder, in einem weiteren Ausführungsbeispiel höchstens 55%, gemäß einer anderen Ausgestaltung höchstens 50%. Mindestens jedoch sind 15%, oder gemäß einem weiteren Ausführungsbeispiel mindestens 25% oder sogar mindestens 30% der Fläche der zweiten Oberfläche des elektromechanischen Wandlerelements elektrisch kontaktiert.

Durch die flächig geringere Kontaktierung des elektromechanischen Wandlerelements wird eine Ableitung des Schalls rückwärts durch den Sensor verhindert und dadurch die Signalqualität verbessert.

Gemäß einer weiteren Weiterbildung der Erfindung ist eine zweite Oberfläche des elektromechanischen Wandlerelements mit einer Koppelschicht akustisch gekoppelt. Bei einer Verwendung von mehreren Koppelschichten handelt es sich hier um die erste Koppelschicht.

Gemäß einer erfindungsgemäßen Ausgestaltung ist das elektromechanische Wandlerelement vom Elektrodenstempel auf die erste Koppelschicht gedrückt. Der Elektrodenstempel stellt sowohl den elektrischen Kontakt zum elektromechanischen Wandlerelement her, als auch den Kraftschluss zum elektromechanischen Wandlerelement. Die zweite Oberfläche des elektromechanischen Wandlerelements, respektive die auf der zweiten Oberfläche des elektromechanischen Wandlerelements angebrachte zweite Elektrode, wird dabei vom Elektrodenstempel auf die erste Koppelschicht gedrückt.

Eine weitere Weiterbildung des erfindungsgemäßen Ultraschallsensors sieht vor, dass der Elektrodenstempel auf das elektromechanische Wandlerelement andrückbar ist, wobei der Anpressdruck des Elektrodenstempels auf das elektromechanische Wandlerelement höchstens 100 N/mm² beträgt, insbesondere höchstens 50 N/mm². Einer anderen Ausgestaltung der Erfindung gemäß beträgt der der Anpressdruck des Elektrodenstempels auf das elektromechanische Wandlerelement weniger als 40 N/mm², in anderen Beispielen weniger als 30 N/mm², beispielsweise gar weniger als 20 N/mm². Gemäß einer weiteren Weiterbildung der erfindungsgemäßen Lösung beträgt der Anpressdruck des Elektrodenstempels auf das elektromechanische Wandlerelement jedoch mindestens 1 N/mm², in einem Ausführungsbeispiel sogar mindestens 5 N/mm².

Gemäß einer ersten Variante der erfindungsgemäßen Lösung ist eine Kraft auf den Elektrodenstempel in Richtung der ersten Oberfläche des elektromechanischen Wandlerelements mittels einer Feder einleitbar.

Die Kraft, welche für den Anpressdruck verantwortlich ist, wird beispielsweise über eine Feder aufgebracht. Durch die Feder wird also die Kraft in den Elektrodenstempel eingeleitet, welche den Elektrodenstempel auf das elektromechanische Wandlerelement drückt und welche das elektromechanische Wandlerelement auf die Koppelschicht drückt. Beispielsweise ist die Kraft durch eine beliebige Anordnung von vorgespannten Tellerfedern erzeugbar. Die Verspannung der Federelemente, in diesem Beispiel der Tellerfedern erfolgt z.B. über einen Schnappmechanismus, z.B. einen Seegerring, oder z.B. über einen Schraubverschluss.

Gemäß einer weiteren Weiterbildung des erfindungsgemäßen Ultraschallsensors ist das elektromechanische Wandlerelement auf die Koppelschicht andrückbar, wobei der Anpressdruck des elektromechanischen Wandlerelements auf die Koppelschicht mindestens 1 N/mm² beträgt.

Eine Ausgestaltung der Erfindung schlägt dabei vor, dass der Anpressdruck des elektromechanischen Wandlerelements auf die Koppelschicht mindestens 1 N/mm², gemäß einer weiteren Ausgestaltung mindestens 2 N/mm², gemäß einer weiteren Ausgestaltung jedoch insbesondere mindestens 5 N/mm² beträgt. Der Anpressdruck des elektromechanischen Wandlerelements auf die Koppelschicht hängt natürlich ab von dem Anpressdruck des Elektrodenstempels auf das elektromechanische Wandlerelement. Somit beträgt erfindungsgemäß der Anpressdruck des elektromechanischen Wandlerelements auf die Koppelschicht höchstens 100 N/mm², beispielsweise sogar höchstens 40 N/mm².

Üblicherweise ist eine Elektrode zur elektrischen Kontaktierung zwischen elektromechanischem Wandlerelement und Koppelschicht angebracht.

Eine weitere Weiterbildung der Erfindung ist darin zu sehen, dass der Ultraschallsensor ein Gehäuse aufweist, welches Gehäuse ein akustische Fenster aufweist, welches akustische Fenster mit der ersten Koppelschicht akustisch koppelbar bzw. gekoppelt ist und über welches akustische Fenster akustische Signale aussendbar und/oder empfangbar sind. Das Gehäuse umgibt dabei das elektromechanische Wandlerelement und den Elektrodenstempel. Handelt es sich bei den akustischen Signalen um Ultraschallsignale, wird das akustische Fenster auch Ultraschallfenster genannt.

Das akustische Fenster bildet somit eine zweite Koppelschicht. Handelt es sich um einen Inline-Sensor, steht das akustische Fenster in direktem Kontakt zum Messmedium. Handelt es sich um einen Clamp-On-Sensor, steht das akustische Fenster mit der Rohrleitung zumindest teilweise in Berührung und die Rohrleitung bildet eine dritte Koppelschicht. Alternativ dazu kann bei einem Clamp-On-Sensor beim Gehäuse auf das akustische Fenster verzichtet werden und die erste Koppelschicht des Sensors berührt die Rohrleitung, welche dann eine zweite Koppelschicht bildet - das Messrohr selbst fungiert als akustisches Fenster.

Bei der ersten Koppelschicht handelt es sich, im Falle der Verwendung eines Gehäuses mit akustischem Fenster, um eine dünne, relativ weiche Festkörper-Zwischenschicht, welche Festkörper-Zwischenschicht sich durch die erfindungsgemäßen Kräfte respektive Anpressdrücke zumindest teilweise plastisch verformen lässt. Es ist ein duktiles Material, insbesondere ein Metall, mit einer Brinellhärte von höchstens 50. Insbesondere beträgt die Brinellhärte maximal 35. Dieses Material ist beispielsweise elektrisch leitfähig. In einer Ausführung der Erfindung ist die erste Koppelschicht aus Blei. Erfindungsgemäß beträgt die Brinellhärte des verwendeten Materials mindestens 1. Blei weist eine Brinellhärte von 4 auf.

Die Koppelschicht ist z.B. weniger als 500µm dick, insbesondere weniger als 200µm, gemäß einer weiteren Ausgestaltung weniger als 100µm dick, oder gar weniger als 50µm dick, oder gemäß einem Ausführungsbeispiel weniger als 20µm dick. Gemäß einer erfindungsgemäßen Variante ist die Koppelschicht bis zu ca. 10µm dick. Sogar eine Dicke von weniger als 10µm scheint technisch kein Problem darzustellen.

Liegt die erste Koppelschicht im Gehäuse lose auf, d.h. ist diese nicht mit dem Gehäuse stoffschlüssig, sondern nur Kraft- und/oder Formschlüssig verbunden, ist der Anpressdruck der Koppelschicht auf das Gehäuse respektive das akustische Fenster des Gehäuses höchstens 100 N/mm², insbesondere höchstens 50 N/mm². Einer anderen Ausgestaltung der Erfindung gemäß beträgt der der Anpressdruck des elektromechanischen Wandlerelements auf das Gehäuse weniger als 40 N/mm², oder gar weniger als 30 N/mm², beispielsweise gar weniger als 20 N/mm². Gemäß einer weiteren Weiterbildung der erfindungsgemäßen Lösung beträgt der Anpressdruck des elektromechanischen Wandlerelements auf das Gehäuse jedoch mindestens 1 N/mm², in einem Ausführungsbeispiel sogar mindestens 5 N/mm².

Liegt die erste Koppelschicht zwischen elektromechanischem Wandlerelement und Gehäuse könnte die erste Koppelschicht auch als Anpassungsschicht bezeichnet werden, wobei hier nicht die Impedanzanpassung im Vordergrund steht, sondern die akustische Kopplung zwischen Wandlerelement und Gehäuse respektive akustischem Fenster. Das Gehäuse besteht beispielsweise aus einem Metall oder einer Metalllegierung, wie z.B. Edelstahl. Da gemäß einer Ausgestaltung der Erfindung das Gehäuse einstückig ausgebildet ist, besteht auch das akustische Fenster aus demselben Material.

Die vom elektromechanischen Wandlerelement erzeugten Ultraschallwellen werden über das Schallfenster in das Messmedium eingekoppelt. Da die thermischen Ausdehnungskoeffizienten und/oder die akustischen Impedanzen von elektromechanischem Wandlerelement und Schallfenster, gemäß einem Ausführungsbeispiel besteht das Gehäuse und das Schallfenster aus Edelstahl, unterschiedlich sein können, kann es bei direktem Kontakt der beiden Bauteile zu Verspannungen und/oder zur Bildung von Luftspalten zwischen den beiden Bauteilen führen, welche wiederum die Schallwellenausbreitung stark behindern - an Luft wird Ultraschall üblicherweise fast vollständig reflektiert. Eine physikalisch-chemische Verbindung dieser beiden Bauteile ist somit zu verhindern, wie z.B. durch die relativ weiche, plastisch verformbare, lose liegende Koppelschicht zwischen elektromechanischem Wandlerelement und Schallfenster.

Gemäß einer weiteren Weiterbildung der erfindungsgemäßen Lösung ist der Elektrodenstempel vom Gehäuse elektrisch isoliert.

Der erfindungsgemäße Ultraschallsensor ist dadurch gebildet, dass der Elektrodenstempel eine strukturierte Oberfläche aufweist, welche strukturierte Oberfläche die erste Oberfläche des elektromechanischen Wandlerelements elektrisch kontaktiert, also diese zumindest teilweise berührt, wobei die strukturierte Oberfläche des Elektrodenstempels durch Ausnehmungen strukturiert ist. Die Struktur ist demnach durch Ausnehmungen gekennzeichnet. Gleichermaßen sind Ausstülpungen denkbar. Der technische Effekt ist, je nach Form und Größe, als gleich anzusehen. Die Ausnehmungen sind dann beispielsweise mit Luft oder einem anderem elektrisch isolierenden Material gefüllt.

Eine weitere Weiterbildung der Erfindung ist, dass die Ausnehmungen der strukturierten Oberfläche des Elektrodenstempels symmetrisch, insbesondere achsensymmetrisch und/oder punktsymmetrisch, beispielsweise um eine oder mehrere gedachte Mittelachsen und/oder um den geometrischen Schwerpunkt der strukturierten Oberfläche des Elektrodenstempels auf der strukturierten Oberfläche des Elektrodenstempels angeordnet sind.

Im Gegensatz dazu sind in einer anderen Ausgestaltung der Erfindung die Ausnehmungen, wie beispielsweise Dellen oder andere Vertiefungen, statistisch auf der strukturierten Oberfläche des Elektrodenstempels verteilt angeordnet.

In einer weiteren Weiterbildung weist die strukturierte Oberfläche des Elektrodenstempels des erfindungsgemäßen Ultraschallsensors mindestens eine konzentrische Riefe auf. Die Ausnehmung ist dann eine Riefe.

Gemäß einer weiteren Weiterbildung der Erfindung weist die strukturierte Oberfläche des Elektrodenstempels mindestens zwei konzentrisch um den geometrischen Schwerpunkt der strukturierten Oberfläche des Elektrodenstempels verlaufende Riefen auf. Ist die strukturierte Oberfläche des Elektrodenstempels näherungsweise kreisrund, weist sie einen Mittelpunkt auf, welcher dann gleich dem geometrischen Schwerpunkt ist. Bei dem geometrischen Schwerpunkt handelt es sich um einen Flächenschwerpunkt. Konzentrische Riefen verlaufen dabei symmetrisch um eine gemeinsame Mitte, hier dem geometrischen Schwerpunkt. Also auch eine gerade Riefe durch den geometrischen Schwerpunkt ist konzentrisch.

Weiterhin ist eine Weiterbildung der Erfindung darin begründet, dass die strukturierte Oberfläche des Elektrodenstempels mindestens eine durch den geometrischen Schwerpunkt der Oberfläche des Elektrodenstempels verlaufende Riefe aufweist.

Gemäß einer weiteren Weiterbildung der Erfindung weist die strukturierte Oberfläche des Elektrodenstempels mindestens zwei durch den geometrischen Schwerpunkt der strukturierten Oberfläche des Elektrodenstempels verlaufende Riefen auf. Ist die strukturierte Oberfläche des Elektrodenstempels näherungsweise kreisrund, weist sie einen Mittelpunkt auf, welcher dann gleich dem geometrischen Schwerpunkt ist, bzw. sie weist eine Mittelachse durch den geometrischen Schwerpunkt auf.

Dabei ist der Querschnitt der Riefe, gemäß einer Weiterbildung der Erfindung, näherungsweise trapezförmig.

Die Breite der Riefen beträgt dabei beispielsweise 0,1 mm bis 2mm oder diese ergibt sich aus dem maximal zulässigen Anpressdruck und ist somit eine Funktion aus unter anderem diesem Parameter. Die Tiefe der Riefen können beispielsweise ebenfalls zwischen 0,1mm und 2mm liegen.

In einer weiteren Weiterbildung des erfindungsgemäßen Ultraschallsensors steht die Breite der Riefe oder der Riefen in einem Verhältnis zur Breite der Kontaktierungsflächen des Elektrodenstempels, welche die erste Oberfläche des elektromechanischen Wandlerelements elektrisch kontaktieren, von 2 zu 1. Allgemein liegt erfindungsgemäß das Verhältnis von Breite einer Kontaktierungsfläche zur Breite einer Riefe im Bereich von 1:1 bis zu 1:4. Dies ist insbesondere bei konzentrischen Riefen der Fall. Als Kontaktierungsflächen werden die Flächen des Elektrodenstempels bezeichnet, welche die erste Oberfläche des elektromechanischen Wandlerelements elektrisch kontaktieren. Die Summe der Kontaktierungsflächen ergibt die Kontaktfläche.

Es sind viele weitere Varianten denkbar das Verhältnis der Kontaktierungsfläche zu der Riefenbreite zu definieren. Beispielsweise ist die Breite der Riefen abhängig von ihrer Position auf der strukturierten Oberfläche, z.B. abhängig vom Abstand zum geometrischen Schwerpunkt der strukturierten Oberfläche. So könnten die Breiten der Riefen und/oder der Kontaktierungsflächen vom Schwerpunkt aus gesehen mit zunehmendem Abstand vom Schwerpunkt nach außen hin zu der abnehmen.

Die strukturierte Oberfläche des Elektrodenstempels ist beispielsweise mit einem spanenden Verfahren, wie z.B. Fräsen, einem Erosionsverfahren oder mittels Laserbearbeitung herstellbar. Aber auch zunächst dafür ungeeignet erscheinende Verfahren wie z.B. Giessen, Prägen, Stanzen oder Ätzen sind denkbar.

Die Kontaktierungsflächen des Elektrodenstempels und/oder die erste und/oder zweite Oberfläche der ersten Koppelschicht und/oder die Oberfläche der zweiten Koppelschicht bzw. des akustischen Fensters, welche mit der ersten Koppelschicht in Kontakt steht, weisen einen arithmetischen Mittenrauhwert von kleiner 5µm, insbesondere kleiner 3µm, beispielsweise kleiner 2µm oder gar kleiner 1,5µm auf. Gleichzeitig ist die Ebenheit kleiner 0,1 mm, insbesondere kleiner 0,05mm, beispielsweise kleiner 0,02mm oder gar kleiner 0,01 mm. Gemäß einer Ausgestaltung ist Rₐ ≤ 1,6 und die Ebenheit, also die Toleranz, in der sich eine ebene Fläche befinden muss, ≤ 0,01 mm.

Das Ultraschall-Durchflussmessgerät kann auch zwei, drei, vier, fünf, sechs oder mehrere der erfindungsgemäßen Ultraschallsensoren aufweisen und nach dem Laufzeitdifferenzprinzip oder dem Dopplerprinzip arbeiten. Des Weiteren kann es sich um ein Inline- oder ein Clamp-On- Ultraschall-Durchflussmessgerät handeln. Weitergebildet zeigt das Ultraschall-Durchflussmessgerät, dass jeweils zwei Ultraschallsensoren auf einer gemeinsamen gedachten Achse in einer Rohrleitung gegenüberliegend angeordnet sind, und wobei der Durchfluss mittels des Laufzeitdifferenzprinzips ermittelbar ist.

Gemäß einer weiteren Weiterbildung des erfindungsgemäßen Ultraschall-Durchflussmessgeräts ist das elektromechanische Wandlerelement in einem Frequenzbereich von 0,5 bis 5 MHz betrieben.

Die Erfindung wird anhand der nachfolgenden Figuren näher erläutert, in denen jeweils ein Ausführungsbeispiel dargestellt ist. Gleiche Elemente sind in den Figuren mit gleichen Bezugszeichen versehen.
- Fig. 1: zeigt perspektivisch einen erfindungsgemäßen Ultraschallsensor im dreidimensionalen Teilschnitt,
- Fig. 2: zeigt einen Elektrodenstempel eines erfindungsgemäßen Ultraschallsensors im Schnitt,
- Fig. 3: zeigt verschiedene Riefenquerschnitte im Schnitt,
- Fig. 4: zeigt verschiedene weitere Ausnehmungsformen in der Draufsicht.

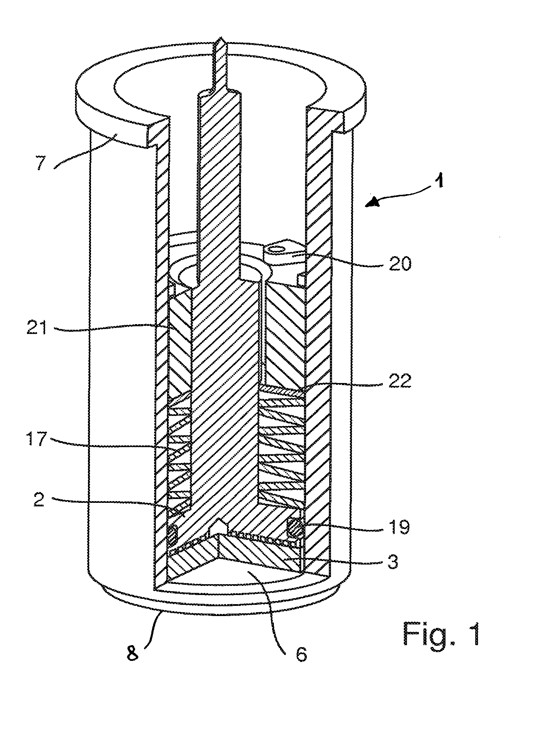

In Fig. 1 ist ein erfindungsgemäßer Ultraschallsensor 1 dreidimensional dargestellt. Er ist hierbei teilweise aufgeschnitten gezeigt. Zu sehen ist ein teilweise aufgeschnittenes, topfförmiges Gehäuse 7, welches die weiteren Bauteile des Ultraschallsensors 1 umfasst. Das Gehäuse 7 weist ein akustisches Fenster oder Ultraschallfenster 8 auf. Hier bildet der Boden des topfförmigen Gehäuses 7 das Ultraschallfenster 8. Das Ultraschallfenster 8, respektive dessen äußere Oberfläche 18, während einer Messung in direktem Kontakt mit einem nicht dargestellten Messmedium. Die innere Oberfläche des Ultraschallfensters hingegen ist mit einer ersten Koppelschicht 6 akustisch gekoppelt. Das Ultraschallfenster 8 könnte somit als zweite Koppelschicht bezeichnet werden.

Die erste Koppelschicht 6 besteht aus Blei, einem duktilen Metall. Das Gehäuse 7 und in diesem Beispiel auch das Ultraschallfenster 8 sind hingegen aus einem Edelstahl hergestellt. Hier ist das Gehäuse einstückig 7 ausgebildet. Das Ultraschallfenster 8 kann in anderen Ausgestaltungen auch separat hergestellt und in das Gehäuse eingebracht werden und dann auch aus einem anderen Werkstoff bestehen. Die Koppelschicht 6 ist hier weniger als 100µm dick; es handelt sich daher um eine relativ weiche Bleifolie. Koppelschicht 6 und Gehäuse 7 sind nicht stoffschlüssig miteinander verbunden. Die Koppelschicht 6 liegt zunächst lose im Gehäuse 7 auf und wird durch eine Kraft, aufgebracht in Richtung des Ultraschallfensters 8 auf das Ultraschallfenster 8 angepresst. Dabei beträgt der Anpressdruck der Koppelschicht auf das Gehäuse 7 respektive auf das akustische Fenster 8 des Gehäuses 7 höchstens 40 N/mm².

Da die Rauheiten der Kontaktflächen zwischen der ersten Koppetschicht 6 und dem Ultraschallfenster 8 jeweils kleiner als 1,6µm sind und die Ebenheiten jeweils kleiner als 0,01mm sind, kommt es bei diesem Druck zu einer plastischen Verformung der ersten Koppelschicht, woraus eine sehr gute akustische Kopplung resultiert.

Das elektromechanische Wandlerelement 3 liegt seinerseits ebenfalls zunächst lose auf der ersten Koppelschicht 6 auf. Der Elektrodenstempel 2 wird mit einem Anpressdruck von höchstens 40 N/mm² auf das elektromechanische Wandlerelement 3 gepresst, wobei dann der Anpressdruck des elektromechanischen Wandlerelements 3 auf die erste Koppelschicht 6 mindestens 5 N/mm² beträgt. Das elektromechanische Wandlerelement 3 wandelt die Ultraschallsignale nach dem Prinzip der Elektrostriktion oder der Magnetostriktion. Unter der Magnetostriktion wird die Längenänderung eines ferromagnetischen Stoffs infolge eines angelegten Magnetfelds verstanden. Die Elektrostriktion hingegen beschreibt die Deformation eines Dielektrikums infolge eines angelegten elektrischen Felds. Die Deformation ist dabei im Allgemeinen nicht abhängig von der Richtung des Felds. Der Piezoeffekt ist somit im Speziellen Teil der Elektrostriktion. In dieser Ausgestaltung ist das elektromechanische Wandlerelement 3 ein piezoelektrisches Element, speziell eine Piezokeramik.

Der Elektrodenstempel 2 selbst wird über Federelemente 17 auf die darunter befindlichen Bauteile gepresst. Die Verspannung der Federelemente, in diesem Beispiel der Tellerfedern 17, erfolgt z.B. über einen Schnappmechanismus, wie hier z.B. über einen Seegerring 20. Zwischen den Tellerfedern 17 und dem Seegering sind in diesem Beispiel noch ein Anpressring 21 und eine Isolationsscheibe 22 angeordnet. Die Isolationsscheibe 22 sorgt zusammen mit dem in den Elektrodenstempel 2 eingelassenen Isolationsring 19 für die elektrische Isolierung von Elektrodenstempel 2 zum Gehäuse 7.

Der hier gezeigte Ultraschallsensor 1 weist wesentlich verbesserte Eigenschaften bezogen auf den einsetzbaren Temperaturbereich und in punkto Signalqualität auf. Die Bauteile des Ultraschallsensors 1, insbesondere die Koppelschicht 6 aus einer Bleifolie, weisen eine Temperaturbeständigkeit von -40°C bis +200°C auf.

Diese Weiterbildung weist somit eine Koppelschicht, z.B. aus Blei, zwischen elektromechanischem Wandlerelement, welches elektromechanische Wandlerelement einen Mittenrauhwert von höchstens 1,6 aufweist und eine Ebenheit von höchstens 0,01 mm, und zwischen akustischem Fenster auf, welches akustische Fenster einen Mittenrauhwert von höchstens 1,6 und eine Ebenheit von höchstens 0,01 mm aufweist, wobei die Koppelschicht mit einer Dicke von mindestens 10 µm und höchstens 100µm unter einem Anpressdruck von mindestens 5 N/mm² bis höchstens 40 N/mm² bei 20°C Umgebungstemperatur und 1013mbar Umgebungsdruck zumindest teilweise plastisch verformbar ist und bei Temperaturen bis 200°C den festen Aggregatszustand beibehält.

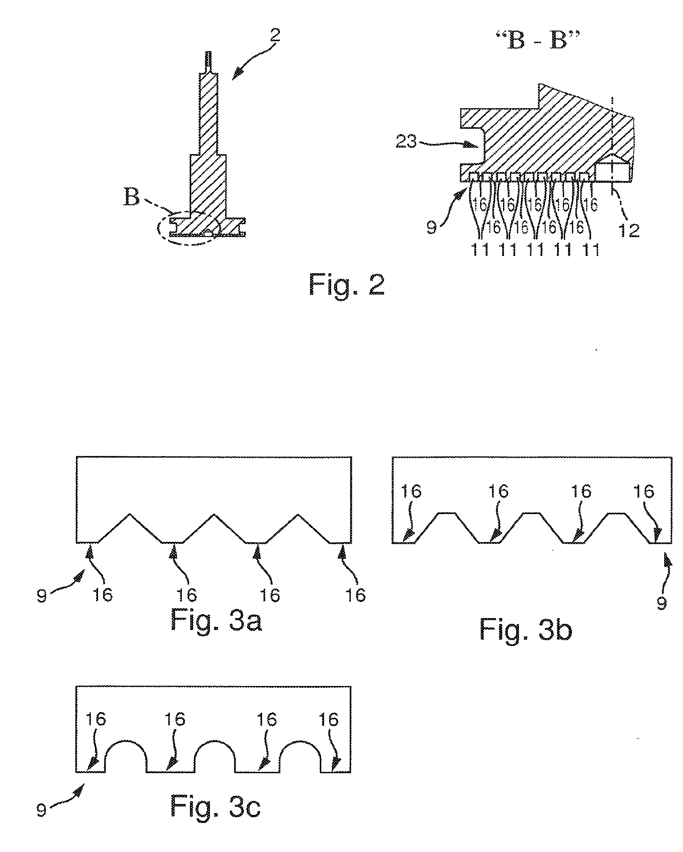

Fig. 2 offenbart einen erfindungsgemäßen Elektrodenstempel 2 im Schnitt. Der Elektrodenstempel 2 weist konzentrisch um den Mittelpunkt 12 der strukturierten Oberfläche 9 umlaufende Riefen 11 in der strukturierten Oberfläche 9 mit einem rechteckigen Querschnitt auf. Wie ebenfalls einbeschrieben ist, beträgt die Rauheit (Mittenrauhwert Ra) der Kontaktierungsflächen 16 der strukturierten Oberfläche 9 1,6 und die Ebenheit dieser Fläche ist 0,01 mm. Die hier gezeigten Riefen sind ca. 0,5mm tief und ca. 0,5mm breit. Die Kontaktierungsflächen 16 zwischen den einzelnen Riefen 11 sind hingegen nur ca. 0,25mm breit. Es stehen also weit weniger als 75% der strukturierten Oberfläche 9 des Elektrodenstempels 2 zur Kontaktierung eines elektromechanischen Wandlerelements zur Verfügung, unter der Annahme, das elektromechanische Wandlerelement verfügt über eine näherungsweise gleich große erste Oberfläche. Weiterhin ist eine umlaufende Nut 23 im Elektrodenstempel 2 gezeigt, um einen Isolationsring aufzunehmen.

In Fig. 3 sind verschiedene Querschnittsprofile von unterschiedlichen Elektrodenstempeln im Schnitt skizziert. Neben dreieckigem Riefenquerschnitt in Fig. 3a sind auch halbrunde Riefen in Fig. 3c veranschaulicht.

Ein Trapez besteht definitionsgemäß aus zwei parallelen Seiten, Trapezbasisseiten genannt und zwei weiteren Seiten welche unter den Winkeln α, δ bzw. β, γ die Trapezbasisseiten zu einem Vieleck verbinden und Trapezschenkel genannt werden. Die Winkel α, δ, β, γ können unterschiedlich groß sein und auch Null werden. Sie bestimmen maßgeblich die Form der Riefe, sind aber der Einfachheit halber nicht in Fig. 3 aufgenommen. Somit sind das Rechteck und/oder das Dreieck extreme Formen eines Trapezes.

Die strukturierte Oberfläche 9 des Elektrodenstempels 2 ist die Oberfläche, welche das elektromechanische Wandlerelement kontaktiert. Nun kontaktiert aber nicht die gesamte strukturierte Oberfläche 9 des Elektrodenstempels 2 das elektromechanische Wandlerelement, sondern nur die Kontaktierungsflächen 16. Weist beispielsweise die strukturierte Oberfläche 9 des Elektrodenstempels 2, welche die erste Oberfläche des elektromechanischen Wandlerelements elektrisch kontaktiert, eine geschlossene ringförmige Riefe auf, ist die strukturierte Oberfläche 9 des Elektrodenstempels 2 in zwei Kontaktierungsflächen 16 aufgeteilt. Die Kontaktierungsflächen 16 liegen dabei in einer gedachten Ebene. Die Breite der Riefe 11 wird dann in einem Querschnitt durch den Elektrodenstempel bemessen als Abstand der beiden benachbarten Punkte der Kontaktierungsflächen 16, welche in dieser gedachten Ebene liegen und gleichzeitig Eckpunkte der Riefe darstellen. Auch die Ebenheit der Kontaktierungsflächen 16 bezieht sich hier auf die gedachte Ebene durch alle Kontaktierungsflächen 16. Die Breite der Kontaktierungsflächen 16 bemisst sich dann natürlich gerade umgekehrt.

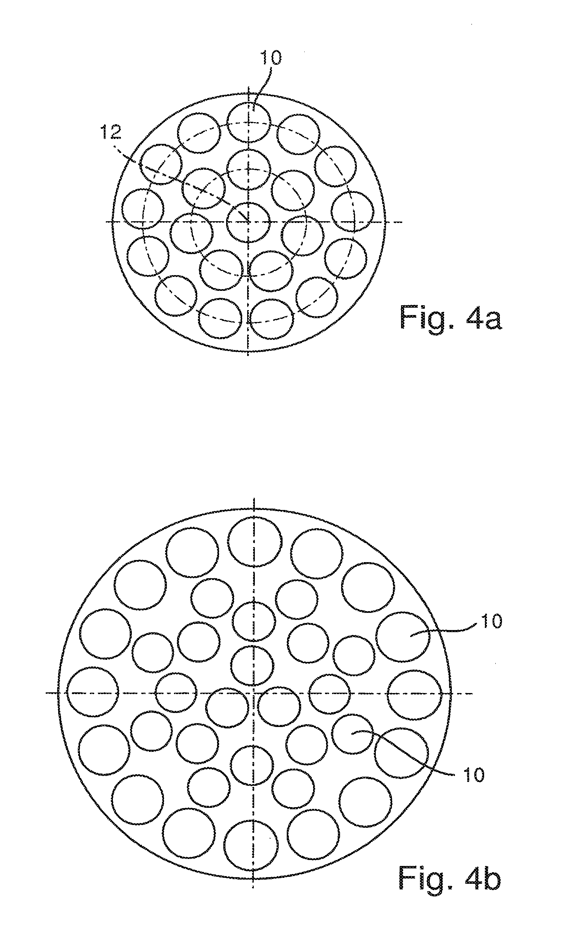

Fig. 4 illustriert verschiedene weitere Ausnehmungsformen in der Draufsicht auf die strukturierte Oberfläche 9 des Elektrodenstempels. Fig. 4a präsentiert dabei halbkugelförmige Dellen 10 gleicher Größe auf konzentrischen Kreisen um den geometrischen Schwerpunkt 12, wobei die Fig. 4b statistisch verteilte kegelförmige Vertiefungen 10 zeigt.

### Bezugszeichenliste

- 1: Ultraschallsensor
- 2: Elektrodenstempel
- 3: Elektromechanisches Wandlerelement
- 4: Erste Oberfläche des elektromechanischen Wandlerelements
- 5: Zweite Oberfläche des elektromechanischen Wandlerelements
- 6: Erste Koppelschicht
- 7: Gehäuse des Ultraschallsensors
- 8: Akustisches Fenster bzw. Ultraschallfenster
- 9: Strukturierte Oberfläche des Elektrodenstempels
- 10: Ausnehmungen
- 11: Riefe
- 12: Geometrischer Schwerpunkt der strukturierten Oberfläche des Elektrodenstempels
- 13: Breite der Riefe
- 14: Tiefe der Riefe
- 15: Breite der Kontaktierungsflächen des Elektrodenstempels
- 16: Kontaktierungsflächen des Elektrodenstempels
- 17: Federelemente
- 18: Äußere Oberfläche des Ultraschallfensters
- 19: Isolationsring
- 20: Seegering
- 21: Anpressring
- 22: Isolationsscheibe
- 23: Nut

## Patentansprüche

1. Ultraschall-Durchflussmessgerät mit einem Ultraschallsensor (1) mit zumindest einem elektromechanischen Wandlerelement (3) und einem Elektrodenstempel (2), welcher eine erste Oberfläche (4) des elektromechanischen Wandlerelements (3) elektrisch kontaktiert,
wobei der Elektrodenstempel (2) so ausgestaltet ist, dass höchstens 75% der Fläche der ersten Oberfläche (4) des elektromechanischen Wandlerelements (3) elektrisch kontaktiert sind, **dadurch gekennzeichnet,** dass der Elektrodenstempel (2) eine strukturierte Oberfläche (9) aufweist, welche die erste Oberfläche (4) des elektromechanischen Wandlerelements (3) elektrisch kontaktiert, wobei die strukturierte Oberfläche (9) des Elektrodenstempels (2) durch Ausnehmungen (10) strukturiert ist und wobei der Elektrodenstempel (2) mittels zumindest eines Federelements (17) auf das Wandlerelement (3) andrückbar ist.

2. Ultraschall-Durchflussmessgerät nach Anspruch 1,
**dadurch gekennzeichnet,**
dass die Ausnehmungen (10) der strukturierten Oberfläche (9) des Elektrodenstempels (2) symmetrisch angeordnet sind.

3. Ultraschall-Durchflussmessgerät nach einem der Ansprüche 1 oder 2,
**dadurch gekennzeichnet,**
dass die strukturierte Oberfläche (9) des Elektrodenstempels (2) mindestens eine konzentrische Riefe (11) aufweist.

4. Ultraschall-Durchflussmessgerät nach einem der Ansprüche 1 bis 3,
**dadurch gekennzeichnet,**
dass die strukturierte Oberfläche (9) des Elektrodenstempels (2) mindestens eine durch den geometrischen Schwerpunkt (12) der Oberfläche des Elektrodenstempels (2) verlaufende Riefe (11) aufweist.

5. Ultraschall-Durchflussmessgerät nach einem der Ansprüche 3 oder 4,
**dadurch gekennzeichnet,**
dass der Querschnitt der Riefe (11) näherungsweise trapezförmig ist.

6. Ultraschall-Durchflussmessgerät nach einem der Ansprüche 3 bis 5,
**dadurch gekennzeichnet,**
dass das Verhältnis der Breite (13) der Riefen (11) zu den Breiten (15) der Kontaktierungsflächen (16) des Elektrodenstempels (2), welche die erste Oberfläche (4) des elektromechanischen Wandlerelements (3) elektrisch kontaktieren, in einem Bereich zwischen 1 zu 1 und 4 zu 1 liegt.

7. Ultraschall-Durchflussmessgerät nach einem der Ansprüche 1 bis 6,
**dadurch gekennzeichnet,**
dass eine zweite Oberfläche (5) des elektromechanischen Wandlerelements (3) mit einer Koppelschicht (6) akustisch gekoppelt ist.

8. Ultraschall-Durchflussmessgerät nach einem der Ansprüche 1 bis 7,
**dadurch gekennzeichnet,**
dass der Elektrodenstempel (2) mittels zumindest eines Federelements (17) auf das elektromechanische Wandlerelement (3) andrückbar ist, wobei der Anpressdruck des Elektrodenstempels (2) auf das elektromechanische Wandlerelement (3) höchstens 100 N/mm², insbesondere höchstens 40 N/mm² beträgt.

9. Ultraschall-Durchflussmessgerät nach einem der Ansprüche 1 bis 8,
**dadurch gekennzeichnet,**
dass das elektromechanische Wandlerelement (3) auf die Koppelschicht (6) andrückbar ist, wobei der Anpressdruck des elektromechanischen Wandlerelements (3) auf die Koppelschicht (6), welcher von zumindest einem Federelement (17) aufbringbar ist, mindestens 1 N/mm² beträgt.

10. Ultraschall-Durchflussmessgerät nach einem der Ansprüche 1 bis 9,
**dadurch gekennzeichnet,**
dass der Ultraschallsensor (1) ein Gehäuse (7) aufweist, welches ein Ultraschallfenster (8) aufweist, welches mit der Koppelschicht (6) akustisch koppelbar ist und über welches Ultraschallfenster (8) Ultraschallsignale aussendbar und/oder empfangbar sind.

11. Ultraschall-Durchflussmessgerät nach Anspruch 10,
**dadurch gekennzeichnet,**
dass der Elektrodenstempel (2) vom Gehäuse (7) elektrisch isoliert ist.

12. Ultraschall-Durchflussmessgerät nach einem der vorhergehenden Ansprüche,
**dadurch gekennzeichnet,**
dass jeweils zwei Ultraschallsensoren (1) auf einer gemeinsamen gedachten Achse in einer Rohrleitung gegenüberliegend angeordnet sind, und wobei der Durchfluss mittels des Laufzeitdifferenzprinzips ermittelbar ist.

13. Ultraschall-Durchflussmessgerät nach einem der vorhergehenden Ansprüche,
**dadurch gekennzeichnet,**
dass das elektromechanische Wandlerelement (3) in einem Frequenzbereich von 0,5 bis 5 MHz betrieben ist.

## Claims

1. Ultrasonic flowmeter with an ultrasonic sensor (1) with at least one electromechanical transducer element (3) and an electrode stamp (2) which electrically contacts a first surface (4) of the electromechanical transducer element (3), wherein the electrode stamp (2) is designed in such a way that a maximum of 75% of the area of the first surface (4) of the electromechanical transducer element (3) is in electrical contact
**characterized in that**
the electrode stamp (2) has a structured surface (9) which electrically contacts the first surface (4) of the electromechanical transducer element (3), wherein the structured surface (9) of the electrode stamp (2) is structured by recesses (10) and wherein the electrode stamp (2) can be pressed against the transducer element (3) via at least one spring element (17).

2. Ultrasonic flowmeter as claimed in Claim 1,
**characterized in that**
the recesses (10) of the structured surface (9) of the electrode stamp (2) are arranged symmetrically.

3. Ultrasonic flowmeter as claimed in one of the Claims 1 or 2,
**characterized in that**
the structured surface (9) of the electrode stamp (2) has at least one concentric groove (11).

4. Ultrasonic flowmeter as claimed in one of the Claims 1 to 3,
**characterized in that**
the structured surface (9) of the electrode stamp (2) has at least one groove (11) passing through the geometric center of gravity (12) of the surface of the electrode stamp (12).

5. Ultrasonic flowmeter as claimed in one of the Claims 3 or 4,
**characterized in that**
the cross-section of the groove (11) is virtually trapezoidal.

6. Ultrasonic flowmeter as claimed in one of the Claims 3 to 5,
**characterized in that**
the ratio of the width (13) of the grooves (11) to the widths (15) of the contact surfaces (16) of the electrode stamp (2), which electrically contact the first surface (4) of the electromechanical transducer element (3), is in a range between 1 to 1 and 4 to 1.

7. Ultrasonic flowmeter as claimed in one of the Claims 1 to 6,
**characterized in that**
a second surface (5) of the electromechanical transducer element (3) is acoustically coupled with a coupling layer (6).

8. Ultrasonic flowmeter as claimed in one of the Claims 1 to 7,
**characterized in that**
the electrode stamp (2) can be pressed against the electromechanical transducer element (3) with at least one spring element (17), wherein the maximum contact pressure of the electrode stamp (2) on the electromechanical transducer element (3) is 100 N/mm², and particularly is 40 N/mm² max.

9. Ultrasonic flowmeter as claimed in one of the Claims 1 to 8,
**characterized in that**
the electromechanical transducer element (3) can be pressed against the coupling layer (6), wherein the contact pressure of the electromechanical transducer element (3) onto the coupling layer (6), which can be applied by at least one spring element (17), is at least 1 N/mm².

10. Ultrasonic flowmeter as claimed in one of the Claims 1 to 9,
**characterized in that**
the ultrasonic sensor (1) has a housing (7), which has an ultrasonic window (8) that can be acoustically coupled with the coupling layer (6) and via said ultrasonic window (8) ultrasonic signals can be transmitted and/or received.

11. Ultrasonic flowmeter as claimed in Claim 10,
**characterized in that**
the electrode stamp (2) is electrically isolated from the housing (7).

12. Ultrasonic flowmeter as claimed in one of the previous claims,
**characterized in that**
two ultrasonic sensors (1) in each case are arranged opposite one another on a common imaginary axis in a pipe, and wherein the flow can be determined using the principle of transit time difference.

13. Ultrasonic flowmeter as claimed in one of the previous claims,
**characterized in that**
the electromechanical transducer element (3) is operated in a frequency range from 0.5 to 5 MHz.

## Revendications

1. Débitmètre à ultrasons avec un capteur à ultrasons (1) avec au moins un élément transducteur électromécanique (3) et un poinçon d'électrode (2), lequel poinçon met en contact électrique une première surface (4) de l'élément transducteur électromécanique (3), le poinçon d'électrode (2) étant conçu de telle sorte qu'un maximum de 75 % de la première surface (4) de l'élément transducteur électromécanique (3) est en contact électrique
**caractérisé en ce**
que le poinçon d'électrode (2) présente une surface (9) structurée, laquelle met en contact électrique la première surface (4) de l'élément transducteur électromécanique (3), la surface structurée (9) du poinçon d'électrode (2) étant structurée par des évidements (10) et le poinçon d'électrode (2) pouvant être pressé contre l'élément transducteur au moyen d'au moins un élément à ressort (17).

2. Débitmètre à ultrasons selon la revendication 1,
**caractérisé en ce**
que les évidements (10) de la surface structurée (9) du poinçon d'électrode (2) sont disposés de façon symétrique.

3. Débitmètre à ultrasons selon l'une des revendications 1 ou 2,
**caractérisé en ce**
que la surface structurée (9) du poinçon d'électrode (2) présente au moins une rainure (11) concentrique.

4. Débitmètre à ultrasons selon l'une des revendications 1 à 3,
**caractérisé en ce**
que la surface structurée (9) du poinçon d'électrode (2) présente au moins une rainure (11) passant par le centre de gravité géométrique (12) de la surface du poinçon d'électrode (12).

5. Débitmètre à ultrasons selon l'une des revendications 3 ou 4,
**caractérisé en ce**
que la section de la rainure (11) est à peu près trapézoïdale.

6. Débitmètre à ultrasons selon l'une des revendications 3 à 5,
**caractérisé en ce**
que le rapport entre la largeur (13) des rainures (11) et les largeurs (15) des surfaces de contact (16) du poinçon d'électrode (2), lesquelles mettent en contact électrique la première surface (4) de l'élément transducteur électromécanique (3), se situe dans une plage comprise entre 1/1 et 4/1.

7. Débitmètre à ultrasons selon l'une des revendications 1 à 6,
**caractérisé en ce**
qu'une deuxième surface (5) de l'élément transducteur électromécanique (3) est couplée avec une couche de couplage (6).

8. Débitmètre à ultrasons selon l'une des revendications 1 à 7,
**caractérisé en ce**
que le poinçon d'électrode (2) peut être pressé contre l'élément transducteur électromécanique (3) au moins au moyen d'un élément à ressort (17), la pression d'appui du poinçon d'électrode (2) sur l'élément transducteur électromécanique (3) s'élevant à 100 N/mm² max., notamment à 40 N/mm² max.

9. Débitmètre à ultrasons selon l'une des revendications 1 à 8,
**caractérisé en ce**
que l'élément transducteur électromécanique (3) peut être pressé sur la couche de couplage (6), la pression d'appui de l'élément transducteur électromécanique (3) sur la couche de couplage (6), laquelle pression peut être appliquée au moins au moyen d'un élément à ressort (17), s'élevant à au moins 1 N/mm².

10. Débitmètre à ultrasons selon l'une des revendications 1 à 9,
**caractérisé en ce**
que le capteur à ultrasons (1) comporte un boîtier (7), lequel présente une fenêtre à ultrasons (8) pouvant être couplée acoustiquement avec la couche de couplage (6), et fenêtre à ultrasons (8) par l'intermédiaire de laquelle les signaux à ultrasons peuvent être émis ou reçus.

11. Débitmètre à ultrasons selon la revendication 10,
**caractérisé en ce**
que le poinçon d'électrode (2) est isolé électriquement du boîtier (7).

12. Débitmètre à ultrasons selon l'une des revendications précédentes, **caractérisé en ce**
que sont disposés respectivement deux capteurs à ultrasons (1) sur un axe imaginaire commun, en opposition dans une conduite, et pour lequel le débit peut être déterminé au moyen du principe de la différence des temps de propagation.

13. Débitmètre à ultrasons selon l'une des revendications précédentes,
**caractérisé en ce**
que l'élément convertisseur électromécanique (3) est utilisé dans une plage de fréquence de 0,5 à 5 MHz.
